(19) Europäisches Patentamt
European Patent Office
Office européen des brevets

(11) EP 2 532 303 A1

(12) **EUROPEAN PATENT APPLICATION**
published in accordance with Art. 153(4) EPC

(43) Date of publication:
**12.12.2012 Bulletin 2012/50**

(51) Int Cl.:
**A61B 5/055** (2006.01)

(21) Application number: **11818200.5**

(22) Date of filing: **16.08.2011**

(86) International application number:
**PCT/JP2011/068565**

(87) International publication number:
**WO 2012/023559 (23.02.2012 Gazette 2012/08)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.08.2010 JP 2010181863**

(71) Applicants:
• **Kabushiki Kaisha Toshiba
Minato-ku
Tokyo 105-8001 (JP)**
• **Toshiba Medical Systems Corporation
Otawara-shi
Tochigi 324-8550 (JP)**

(72) Inventors:
• **ICHINOSE, Nobuyasu
Otawara-shi
Tochigi 324-8550 (JP)**
• **WATANABE, Yoshiteru
Otawara-shi
Tochigi 324-8550 (JP)**

(74) Representative: **Granleese, Rhian Jane
Marks & Clerk LLP
90 Long Acre
London WC2E 9RA (GB)**

(54) **MAGNETIC RESONANCE IMAGING DEVICE**

(57) In a magnetic resonance imaging apparatus (100) according to an embodiment, an array coil (8a to 8e) is structured by arranging a plurality of coil elements each of which receives a magnetic resonance signal generated from a subject. An acquisition controlling unit (17a, 27a) acquires the magnetic resonance signals while changing a position to be selected and excited within the subject who has the array coil (8a to 8e) attached thereon. A large-area image generating unit (13a, 23a) generates a large-area image of the subject, based on the magnetic resonance signals acquired by the acquisition controlling unit (17a, 27a). A position measuring unit (13d, 23a) measures positions of the coil elements, based on strengths of the magnetic resonance signals used for generating the large-area image and positions of the couchtop corresponding to the times when the magnetic resonance signals were acquired.

FIG.5

EP 2 532 303 A1

**Description**

Field

Exemplary embodiments of the present invention relate to a magnetic resonance imaging apparatus. Background

As a technique related to magnetic resonance imaging apparatuses, a method is conventionally known by which an image having a large-area in a body-axis direction of a subject is generated by repeatedly acquiring magnetic resonance signals by selecting and exciting cross sections perpendicular to a moving direction of a couchtop, while moving the couchtop on which the subject is placed. Another method is also known by which, when an array coil including a plurality of coil elements is used as a receiving coil for receiving magnetic resonance signals, the magnetic resonance signals are acquired by using the array coil, and further, the position of the receiving coil is measured based on the acquired magnetic resonance signals.

Citation List

Patent Literature

Patent Literature 1: Japanese Patent Application Laid-open No. 10-179551
Patent Literature 2: Specification for United States Granted Patent No. 6794872

Summary

Technical Problem

According to the conventional techniques, however, when it is necessary to take a large-area image of a subject and measure the position of a receiving coil, it is required to perform these processes individually. Consequently, it takes a long time to complete a medical examination.

Solution to Problem

A magnetic resonance imaging apparatus according to an embodiment has an array coil, an acquisition controlling unit, a large-area image generating unit, and a position measuring unit. The array coil is structured by arranging a plurality of coil elements therein each of which receives a magnetic resonance signal generated from a subject. The acquisition controlling unit acquires the magnetic resonance signals, while changing a position to be selected and excited within the subject who has the array coil attached thereon. The large-area image generating unit generates a large-area image of the subject, based on the magnetic resonance signals acquired by the acquisition controlling unit. The position measuring unit measures positions of the coil elements, based on strengths of the magnetic resonance signals used for generating the large-area image and positions of the couchtop corresponding to times when the magnetic resonance signals were acquired. Brief Description of Drawings

FIG. 1 is a diagram of an overall configuration of an MRI apparatus according to a first embodiment.
FIG. 2 is a drawing of an example of an array coil according to the first embodiment.
FIG. 3 is a functional block diagram of a detailed configuration of a computer system according to the first embodiment.
FIG. 4 is a drawing of an example of coil position information stored in a coil position information storage unit according to the first embodiment.
FIG. 5 is a drawing for explaining a data acquisition performed by a data acquisition controlling unit according to the first embodiment.
FIG. 6 is a drawing of an example of a large-area image generated by a large-area image generating unit according to the first embodiment.
FIG. 7 is a drawing of an example of profile data for a coil element generated by a profile data generating unit according to the first embodiment.
FIG. 8 is a drawing of an example of profile data for a Whole-Body (WB) coil generated by the profile data generating unit according to the first embodiment.
FIG. 9 is a drawing for explaining an array coil position measuring process performed by a coil position measuring unit according to the first embodiment.
FIG. 10 is a flowchart of a flow in a process performed by the MRI apparatus according to the first embodiment.
FIG. 11 is a functional block diagram of a detailed configuration of a computer system according to a second embodiment.
FIG. 12 is a drawing of exemplary array coil images for coil elements 80 generated by an image data generating unit according to the second embodiment.
FIG. 13 is a drawing of exemplary WB coil images generated by the image data generating unit according to the second embodiment.
FIG. 14 is a flowchart of a flow in a process performed by an MRI apparatus according to the second embodiment.
FIG. 15 is a drawing for explaining a data acquisition performed by a data acquisition controlling unit according to a third embodiment.

Description of Embodiments

In the following sections, exemplary embodiments of a magnetic resonance imaging apparatus will be explained in detail, with reference to the accompanying drawings. In the exemplary embodiments below, magnetic resonance imaging apparatuses will be referred to as "MRI apparatuses". Further, magnetic resonance signals will be referred to as "MR signals".

<First Embodiment>

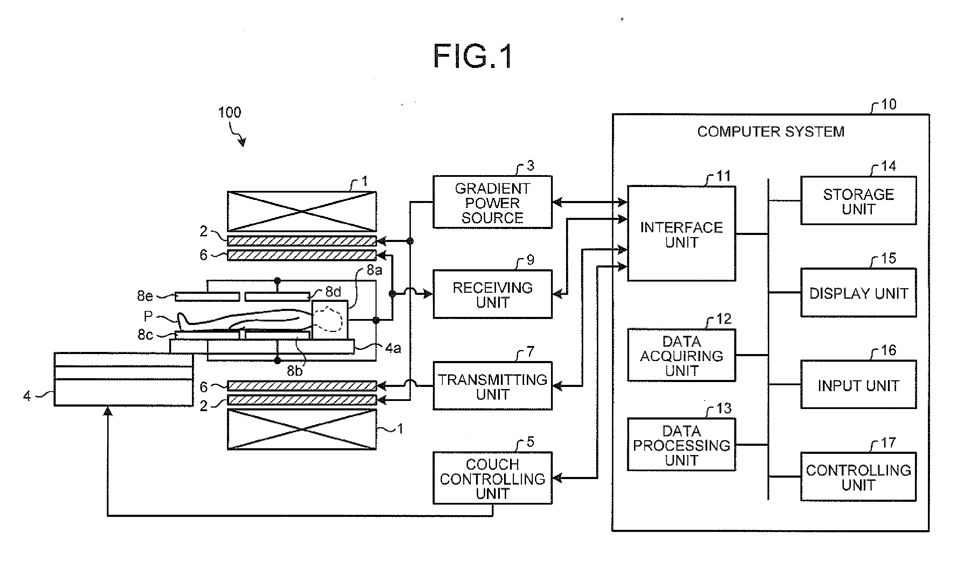

To begin with, a first embodiment will be explained. FIG. 1 is a diagram of an overall configuration of an MRI apparatus according to the first embodiment. As shown in FIG. 1, an MRI apparatus 100 according to the first embodiment includes: a magnetostatic field magnet 1, a gradient coil 2, a gradient power source 3, a couch 4, a couch controlling unit 5, a Whole-Body (WB) coil 6, a transmitting unit 7, array coils 8a to 8e, a receiving unit 9, and a computer system 10.
The magnetostatic field magnet 1 is formed in the shape of a hollow circular cylinder and generates a uniform magnetostatic field in the space on the inside thereof. The magnetostatic field magnet 1 may be configured by using, for example, a permanent magnet, a superconductive magnet, or the like.
The gradient coil 2 is formed in the shape of a hollow circular cylinder and is disposed on the inside of the magnetostatic field magnet 1. The gradient coil 2 is structured by combining three coils that respectively correspond to X-, Y-, and Z-axes that are orthogonal to one another. By individually receiving a supply of electric current from the gradient power source 3 (explained later), each of the three coils generates a gradient magnetic field of which the magnetic field strength changes along the corresponding one of the X-, Y-, and Z-axes. In this situation, the Z-axis direction is the same as the direction of the magnetostatic field. Further, the X-axis direction is a direction that is perpendicular to the Z-axis direction and is horizontal. The Y-axis direction is an up-and-down direction that is perpendicular to the Z-axis direction.
In this situation, the gradient magnetic fields on the X-, Y-, and Z- axes that are generated by the gradient coil 2 correspond to, for example, a read-out-purpose gradient magnetic field Gr, a phase-encoding-purpose gradient magnetic field Ge, and a slice-selecting-purpose gradient magnetic field Gs, respectively. The read-out-purpose gradient magnetic field Gr is used for changing the frequency of an MR signal according to a spatial position. The phase-encoding-purpose gradient magnetic field Ge is used for changing the phase of an MR signal according to a spatial position. The slice-selecting-purpose gradient magnetic field Gs is used for determining an image-taking cross section in an arbitrary manner.
Under control of the computer system 10, the gradient power source 3 supplies the electric current to the gradient coil 2, according to a pulse sequence that is set according to an image taking site or an image taking purpose.
The couch 4 includes a couchtop 4a on which a subject P is placed. Under control of the couch controlling unit 5 (explained later), while the subject P is placed thereon, the couchtop 4a is inserted into the hollow (i.e., an image taking aperture) of the gradient coil 2. Normally, the couch 4 is provided so that the longitudinal direction of the couchtop 4a extends parallel to the central axis of the magnetostatic field magnet 1.
Under control of the computer system 10, the couch controlling unit 5 drives the couch 4 so that the couchtop 4a moves in the longitudinal direction and in an up-and-down direction.
The WB coil 6 is positioned so as to surround the subject P and receives an MR signal generated from the subject P. For example, the WB coil 6 is disposed on the inside of the gradient coil 2 so as to select and excite arbitrary cross-sections of the subject P, by receiving a supply of a radio-frequency pulse from the transmitting unit 7 and applying a radio-frequency magnetic field to the subject P. Further, the WB coil 6 receives an MR signal generated from the subject P due to an influence of the radio-frequency magnetic field.
Under control of the computer system 10, the transmitting unit 7 transmits the radio-frequency pulse corresponding to a Larmor frequency to the WB coil 6, according to a pulse sequence that is set according to an image taking site or an image taking purpose.

The array coils 8a to 8e are attached onto the subject and receive the MR signals generated from the subject P. Each of the array coils is structured by arranging a plurality of coil elements each of which receives the MR signal generated from the subject P. Further, when having received the MR signal, each of the coil elements outputs the received MR signal to the receiving unit 9.

Each of the array coils 8a to 8e is provided in correspondence with an image-taking target site. Each of the array coils 8a to 8e is positioned in the corresponding image-taking target site. For example, the array coil 8a is used in an image taking process for the head and is positioned at the head of the subject P. Further, the array coils 8b and 8c are used in an image taking process for the spine and are positioned between the back of the subject P and the couchtop 4a. As another example, the array coils 8d and 8e are used in an image taking process for the abdomen and are positioned on the abdomen side of the subject.

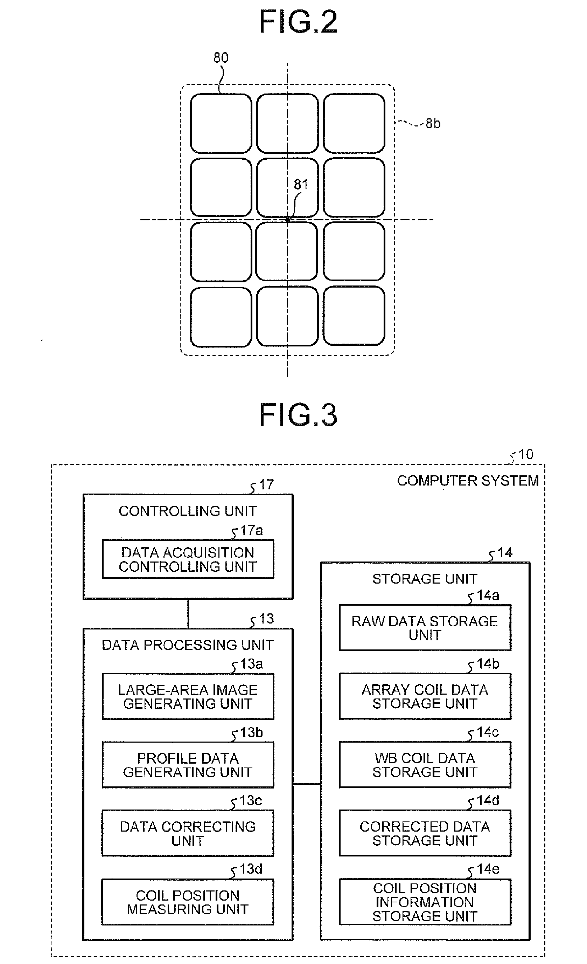

Next, an example of the array coils 8a to 8e will be explained. FIG. 2 is a drawing of an example of the array coil 8b according to the first embodiment. In the explanation below, the array coil 8b, which is a coil for the spine, will be used as an example. As shown in FIG. 2, the array coil 8b includes, for example, twelve coil elements 80 arranged in a formation with 3 columns and 4 rows. The number of coil elements included in each of the array coils is not limited to twelve. An appropriate number of coil elements are arranged in each of the array coils, according to the size and/or the shape of the image-taking target site.

Further, in the first embodiment, for each of the array coils, a representative position is defined in an arbitrary position within the array coil. The representative position is used for expressing the position of each of the coil elements included in the array coil as a relative position. For example, in the array coil 8b shown in FIG. 2, a representative position 81 is defined at the center of the array coil.

Under control of the computer system 10, the receiving unit 9 detects the MR signals output from the WB coil 6 and the array coils 8a to 8e, according to a pulse sequence set by an operator according to an image taking site or an image taking purpose. Further, the receiving unit 9 generates raw data by digitalizing the detected MR signals and transmits the generated raw data to the computer system 10.

Further, the receiving unit 9 includes a plurality of receiving channels used for receiving the MR signals output from the WB coil 6 and the coil elements included in the array coils 8a to 8e. When being notified by the computer system 10 of the coil elements to be used in an image taking process, the receiving unit 9 assigns a receiving channel to the indicated coil elements so that the MR signals output from the indicated coil elements can be received. As a result, for example, the receiving unit 9 is able to receive the MR signals, by switching between the WB coil 6 and the array coils 8a to 8e.

Further, the receiving unit 9 also has a function of synthesizing MR signals received by two or more coil elements selected by the operator from among the plurality of coil elements included in one array coil.

The computer system 10 exercises overall control of the MRI apparatus 100, and also, performs a data acquisition, an image reconstructing process, and the like. The computer system 10 includes an interface unit 11, a data acquiring unit 12, a data processing unit 13, a storage unit 14, a display unit 15, an input unit 16, and a controlling unit 17.

The interface unit 11 is connected to the gradient power source 3, the couch controlling unit 5, the transmitting unit 7, and the receiving unit 9. The interface unit 11 controls inputs and outputs of signals given and received between these functional units connected and the computer system 10.

The data acquiring unit 12 acquires the raw data transmitted from the receiving unit 9 via the interface unit 11. The data acquiring unit 12 stores the acquired raw data into the storage unit 14.

The data processing unit 13 generates spectrum data or image data of a desired nuclear spin within the subject P, by applying a post-processing process i.e., a reconstructing process such as a Fourier transform, to the raw data stored in the storage unit 14. Further, the data processing unit 13 stores the generated various types of data into the storage unit 14. The data processing unit 13 will be explained further in detail later.

The storage unit 14 stores therein, for each subject P, the raw data acquired by the data acquiring unit 12 and the data generated by the data processing unit 13. The storage unit 14 will be explained further in detail later.

The display unit 15 displays various types of information including the spectrum data or the image data generated by the data processing unit 13. The display unit 15 may be configured by using, for example, a display device such as a liquid crystal display device.

The input unit 16 receives various types of operations and inputs of information from the operator. The input unit 16 may be configured by using any of the following as appropriate: a pointing device such as a mouse and/or a trackball; a selecting device such as a mode changing switch; and an input device such as a keyboard.

The controlling unit 17 includes a Central Processing Unit (CPU), a memory, and the like (not shown) and exercises control over the MRI apparatus 100 in an integrated manner by controlling the functional units described above. The controlling unit 17 will be explained further in detail later.

An overall configuration of the MRI apparatus 100 according to the first embodiment has thus been explained. In this configuration, according to the first embodiment, the computer system 10 acquires the MR signals by repeatedly selecting and exciting cross sections perpendicular to the moving direction of the couchtop 4a, while continuously moving the couchtop 4a on which the subject P having the array coils 8a to 8e attached thereon is placed. Further, the computer system 10 generates a large-area image of the subject P based on the acquired MR signals, and also, measures the positions of the coil elements 8a to 8e, based on the strengths of the MR signals used for generating the large-area image and the positions of the couchtop 4a corresponding to the times when the MR signals were acquired.

More specifically, the MRI apparatus 100 according to the first embodiment takes the large-area image of the subject and measures the positions of the receiving coils, by using the same set of MR signals that are acquired by moving the couchtop one time. As a result, according to the first embodiment, when it is necessary to take a large-area image of a subject and measure the positions of the receiving coils, it is possible to reduce the number of times the couch needs to be moved. Consequently, it is possible to shorten the time period required by the medical examination.

In the following sections, details of the MRI apparatus 100 configured as described above will be explained, while a focus is placed on functions of the computer system 10. In the first embodiment, an example is explained in which the array coil 8b is used for taking a large-area image and measuring the positions of the coil elements; however, it is possible to take a large-area image and measure the positions of the coil elements similarly, by using any other array coil.

FIG. 3 is a functional block diagram of a detailed configuration of the computer system 10 according to the first embodiment. FIG. 3 depicts configurations of the data processing unit 13, the storage unit 14, and the controlling unit 17 included in the computer system 10 shown in FIG. 1.

As shown in FIG. 3, the storage unit 14 includes a raw data storage unit 14a, an array coil data storage unit 14b, a WB coil data storage unit 14c, a corrected data storage unit 14d, and a coil position information storage unit 14e.

The raw data storage unit 14a stores therein, for each subject P, the raw data acquired by the data acquiring unit 12.

The array coil data storage unit 14b stores therein profile data generated based on the MR signals received by the array coils 8a to 8e. The profile data is generated by a profile data generating unit 13b, which is explained later.

The WB coil data storage unit 14c stores therein profile data generated based on the MR signals received by the WB coil 6. The profile data is generated by the profile data generating unit 13b, which is explained later.

The corrected data storage unit 14d stores therein corrected data obtained by correcting, based on the strength of the MR signals received by the WB coil 6, fluctuations in the signal strengths of the MR signals acquired by the coil elements, the fluctuations being caused by characteristic differences among different parts of the subject P. The corrected data is generated by a data correcting unit 13c, which is explained later.

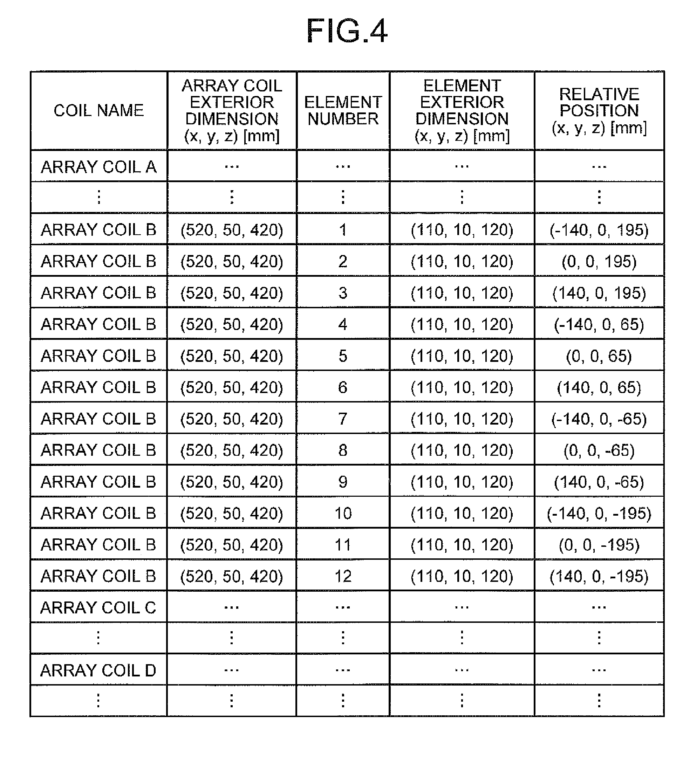

The coil position information storage unit 14e stores therein coil position information indicating physical positions of the coil elements that are expressed while using the representative position set for each of the array coils 8a to 8e as a reference. FIG. 4 is a drawing of an example of the coil position information stored in the coil position information storage unit 14e according to the first embodiment. As shown in FIG. 4, for example, the coil position information storage unit 14e stores therein, as the coil position information, information in which "coil names", "array coil exterior dimensions", "element numbers", "element exterior dimensions", and "relative positions" are kept in correspondence with one another.

Each of the coil names is identification information for identifying the type of array coil in a one-to-one correspondence. For example, in the example shown in FIG. 4, "the array coil A" identifies the array coil 8a used in an image taking process for the head of the subject. Further, the "array coil B" identifies the array coils 8b and 8c used in an image taking process for the spine. Also, the "array coil C" identifies the array coils 8d and 8e used in an image taking process for the abdomen.

Each of the array coil exterior dimensions is information indicating the exterior dimension of the array coil. The exterior dimension of an array coil is expressed by using the lengths in the directions of the x-, the y-, and the z- axes. For instance, in the example shown in FIG. 4, it is indicated that the exterior dimension of the array coil B in the x-axis direction is 520 millimeters, whereas the exterior dimension in the y-axis direction is 50 millimeters, and the exterior dimension in the z-taxis direction is 420 millimeters.

Each of the element numbers is a number for identifying, for each of the array coils, each of the coil elements included in the array coil, in a one-to-one correspondence. For instance, in the example shown in FIG. 4, it is indicated that the array coil B includes twelve coil elements identified with number "1" to number "12".

Each of the element exterior dimensions is information indicating the exterior dimension of the corresponding one of the coil elements included in the array coil. The exterior dimension of a coil element is expressed by using the lengths in the directions of the x-, the y-, and the z- axes. For instance, in the example shown in FIG. 4, it is indicated that the exterior dimension of each of the coil elements included in the array coil B in the x-axis direction is 110 millimeters, whereas the exterior dimension in the y-axis direction is 10 millimeters, and the exterior dimension in the z-axis direction is 120 millimeters.

Each of the relative positions is information indicating the physical position of the corresponding one of the coil elements that is expressed while using the representative position being set to the array coil as a reference. For example, the relative position can be expressed by using relative coordinates (x,y,z) in the directions of the x-, the y-, and the z- axes, while using the representative position being set in an arbitrary position within the array coil as the origin. For instance, in the example shown in FIG. 4, it is indicated that the relative position of the coil element included in the array coil B and identified with the coil element number "1" is (-140, 0, 195), whereas the relative position of the coil element included in the array coil B and identified with the coil element number "2" is (0, 0, 195).

Returning to the description of FIG. 3, the controlling unit 17 includes a data acquisition controlling unit 17a.

The data acquisition controlling unit 17a acquires the MR signals from the subject P by generating the pulse sequence based on an image taking condition set by the operator and controlling the gradient power source 3, the couch controlling unit 5, the transmitting unit 7, and the receiving unit 9 according to the generated pulse sequence. The pulse sequence in this situation is information indicating a procedure for scanning the subject P, such as a strength level and supply timing of the electric power source supplied from the gradient power source 3 to the gradient coil 2, a strength level and transmission timing of the radio-frequency pulse transmitted by the transmitting unit 7 to the WB coil 6, and timing with which the MR signals are detected by the receiving unit 9.

In the first embodiment, the data acquisition controlling unit 17a acquires the MR signals by repeatedly selecting and exciting the cross sections perpendicular to the moving direction of the couchtop 4a, while continuously moving the couchtop 4a on which the subject P having the array coil 8b attached thereon is placed.

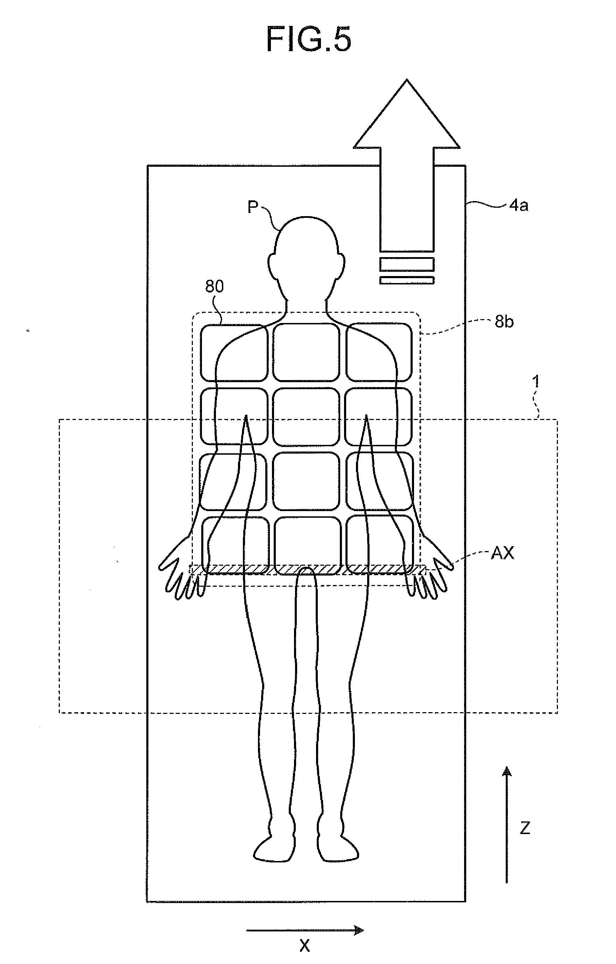

FIG. 5 is a drawing for explaining a data acquisition performed by the data acquisition controlling unit 17a according to the first embodiment. As shown in FIG. 5, more specifically, the data acquisition controlling unit 17a continuously moves, in the Z-axis direction, the couchtop 4a on which the subject P having the array coil 8b attached thereon is placed. In this situation, the subject P is placed on the couchtop 4a so that the body axis thereof extends along the Z-axis direction. Further, the data acquisition controlling unit 17a repeatedly executes the pulse sequence for acquiring the MR signals by selecting and exciting an axial cross-section AX perpendicular to the moving direction of the couchtop 4a, while moving the couchtop 4a.

Further, in the first embodiment, the data acquisition controlling unit 17a acquires the MR signals corresponding to the one-dimensional direction (i.e., a Read Out [RO] direction) perpendicular to the moving direction of the couchtop 4a. For example, by repeatedly executing a pulse sequence for a one-dimensional line scan, the data acquisition controlling unit 17a acquires the MR signals corresponding to the X-axis direction. Further, the data acquisition controlling unit 17a repeatedly performs the data acquisition by controlling the receiving unit 9 so as to alternately switch between the array coil 8b and the WB coil 6, every time MR signals are acquired.

Returning to the description of FIG. 3, the data processing unit 13 includes a large-area image generating unit 13a, the profile data generating unit 13b, the data correcting unit 13c, and a coil position measuring unit 13d.

The large-area image generating unit 13a generates the large-area image of the subject P, based on the MR signals acquired by the data acquisition controlling unit 17a. More specifically, the large-area image generating unit 13a reads, from the raw data storage unit 14a, the raw data based on the MR signals received by the coil elements included in the array coil 8b and generates the image of the subject P having a large area in the Z-axis direction, from the read raw data.

More specifically, the pieces of raw data based on the MR signals that are acquired, in a time sequence, by the data acquisition controlling unit 17a are sequentially read, according to the time sequence, by the large-area image generating unit 13a. The large-area image generating unit 13a then generates a plurality of pieces of data expressing a real space in the one-dimensional direction by applying a one-dimensional Fourier transform to each of the read pieces of raw data. Further, by arranging the pieces of data generated by the one-dimensional Fourier transform into the real space in an order according to the time sequence, the large-area image generating unit 13a generates the large-area image of the subject P. In this situation, the large-area image generating unit 13a determines the positioning intervals between the pieces of data in the real space, according to the moving amounts of the couchtop 4a in the time intervals with which the MR signals were acquired. By arranging the pieces of data in the real space according to the moving amounts of the couchtop 4a in this manner, it is possible to generate the large-area image that properly expresses the shape of the subject.

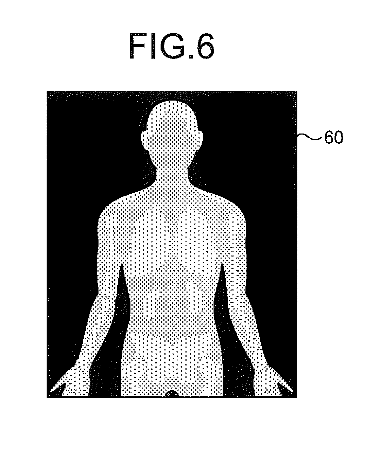

FIG. 6 is a drawing of an example of the large-area image generated by the large-area image generating unit 13a according to the first embodiment. As shown in FIG. 6, for example, the data acquisition controlling unit 17a generates an image having a large area in the body-axis direction of the subject P, as a large-area image 60.

Returning to the description of FIG. 3, based on the MR signals received by each of the plurality of coil elements 80 included in the array coils 8a to 8e, the profile data generating unit 13b generates, for each of the coil elements 80, profile data indicating a distribution of the strengths of the MR signals in the one-dimensional direction perpendicular to the moving direction of the couchtop 4a.

More specifically, the profile data generating unit 13b reads the raw data based on the MR signals acquired by each of the coil elements included in the array coil 8b, out of the raw data storage unit 14a. In this situation, the profile data generating unit 13b reads the raw data used by the large-area image generating unit 13a to generate the large-area image. In this situation, because the profile data generating unit 13b uses the same raw data as the raw data used for generating the large-area image, it becomes possible to both take the large-area image and measure the positions of the coil elements, based on the same set of MR signals that are acquired by moving the couchtop one time.

Further, from the read raw data, the profile data generating unit 13b generates, for each of the coil elements, the profile data indicating the distribution of the strengths of the MR signals in the X-axis direction. For example, the profile data generating unit 13b generates the profile data for each of the coil elements, by applying a one-dimensional Fourier transform to the raw data. Further, the profile data generating unit 13b stores the profile data generated for each of the coil elements into the array coil data storage unit 14b.

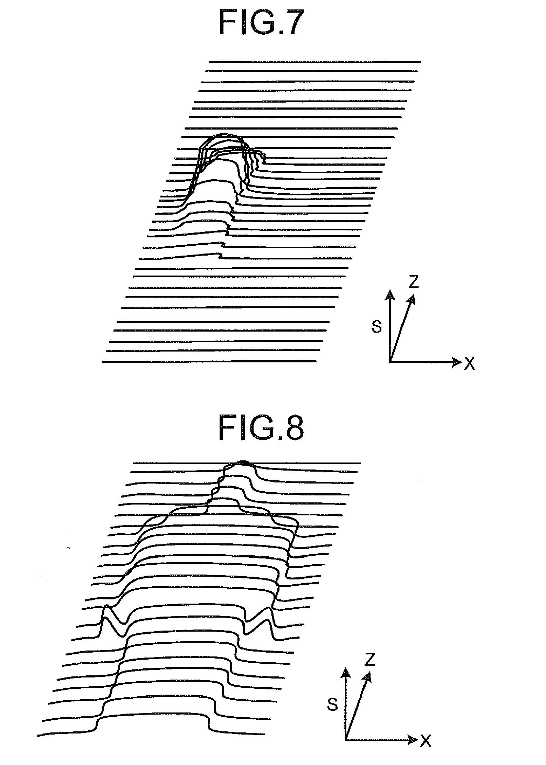

FIG. 7 is a drawing of an example of the profile data for the coil element 80 generated by the profile data generating unit 13b according to the first embodiment. In FIG. 7, the S-axis expresses the strengths of the MR signals. Further, the X-axis expresses the spatial position in the X-axis direction. Also, the Z-axis expresses the spatial position in the Z-axis direction. In this situation, the spatial positions in the X-axis and the Z-axis directions are expressed by using a couch coordinate system that uses a predetermined position on the couchtop 4a as the origin. For example, the origin of the couch coordinate system is set at the center of the couchtop 4a. The couch coordinate system is configured so that the entire coordinate system moves in the Z-axis direction, as the couchtop 4a moves.

As shown in FIG. 7, the profile data generating unit 13b generates the profile data for the coil element, for each of the positions of the couchtop 4a in the Z-axis direction corresponding to the points in time when the MR signals on which the profile data is based were acquired. For example, every time a piece of profile data is generated, the profile data generating unit 13b obtains, from the controlling unit 17, a moving amount of the couchtop 4a corresponding to the time when the MR signals on which the piece of profile data is based were acquired, calculates the position of the couchtop 4a based on the obtained moving amount, and brings the calculated position into correspondence with the piece of profile data.

Further, the profile data generating unit 13b reads the raw data based on the MR signals acquired by the WB coil 6 out of the raw data storage unit 14a and generates profile data indicating a distribution of the strengths of the MR signals in the X-axis direction, based on the read raw data. For example, like the profile data related to the coil elements, the profile data generating unit 13b generates the profile data for the WB coil, by applying a one-dimensional Fourier transform to the raw data. Further, the profile data generating unit 13b stores the profile data generated for the WB coil 6 into the WB coil data storage unit 14c.

FIG. 8 is a drawing of an example of the profile data for the WB coil 6 generated by the profile data generating unit 13b according to the first embodiment. In FIG. 8, the S-axis expresses the strengths of the MR signals. Further, the X-axis expresses the spatial position in the X-axis direction. Also, the Z-axis expresses the spatial position in the Z-axis direction. In this situation, the spatial positions in the X-axis and the Z-axis directions are expressed by using the couch coordinate system described above, like in the profile data for the element coils.

As shown in FIG. 8, the profile data generating unit 13b generates the profile data for the WB coil, for each of the positions of the couchtop 4a in the Z-axis direction corresponding to the points in time when the MR signals on which the profile data is based were acquired. For example, every time a piece of profile data is generated, the profile data generating unit 13b obtains, from the controlling unit 17, a moving amount of the couchtop 4a corresponding to the time when the MR signals on which the piece of profile data is based were acquired, calculates the position of the couchtop 4a based on the obtained moving amount, and brings the calculated position into correspondence with the piece of profile data.

Returning to the description of FIG. 3, based on the strengths of the MR signals received by the WB coil 6, the data correcting unit 13c corrects fluctuations in the signal strengths of the MR signals acquired by the coil elements, the fluctuations being caused by characteristic differences among different parts of the subject P.

More specifically, the data correcting unit 13c reads the profile data for each of the coil elements included in the array coil 8b out of the array coil data storage unit 14b, and also, reads the profile data for the WB coil 6 out of the WB coil data storage unit 14c. Further, the data correcting unit 13c generates corrected data obtained by correcting the profile data for each of the coil elements, by dividing the strength of the MR signal in the profile data for each of the coil elements by the strength of the MR signal in the profile data for the WB coil 6. After that, the data correcting unit 13c stores the generated corrected data into the corrected data storage unit 14d.

Each of the coil elements is configured so as to receive the MR signals generated from one part of the subject P. For this reason, the strengths of the MR signals received by the different coil elements are different from one another, because of the characteristics of the part of the subject P where each of the coil elements is placed, even if the sensitivity levels of the coil elements are equal. In contrast, the WB coil is configured so as to receive the MR signals generated from the entirety of the subject P. For this reason, the MR signals received by the WB coil express a spatial distribution of the MR signals generated from the entirety of the subject P. Accordingly, by correcting the profile data for each of the coil elements based on the profile data for the WB coil 6, it is possible to correct the fluctuations in the strengths of the MR signals, the fluctuations being caused by the characteristic differences among the different parts of the subject.

The coil position measuring unit 13d measures the positions of the coil elements, based on the strengths of the MR signals used for generating the large-area image and the positions of the couchtop 4a corresponding to the times when the MR signals were acquired.

More specifically, the coil position measuring unit 13d reads the corrected data for the coil elements included in the array coil 8b out of the corrected data storage unit 14d and extracts only such signals of which the signal values exceed a predetermined threshold, from among the signals included in the read corrected data. In this situation, because the coil position measuring unit 13d uses only such signals of which the signal values (i.e., the signal strengths) exceed the predetermined threshold, signals that are considered to be noises are eliminated from the MR signals received by the coil elements. As a result, because the position of the representative position of the receiving coils is calculated by using only the signals having a high reliability, it is possible to measure the positions of the coil elements more precisely.

Further, for example, by calculating the position of a gravity point of the signal values of the extracted signals, the coil position measuring unit 13d calculates the positions of the coil elements. In this situation, for example, the position Wz of the gravity point in the Z-axis direction can be calculated by using Expression (1) shown below, where the spatial position in the X-axis direction is expressed as Xi, whereas the position of the couchtop 4a in the Z-axis direction corresponding to the point in time when the MR signal was acquired is expressed as Zj, and the signal value at a point (Xi, Zj) is expressed as Sij.

$$Wz = \sum (Sij \times Zi) / \sum Sij \qquad (1)$$

Further, the position Wx of the gravity point in the X-axis direction can be calculated by using Expression (2) shown below.

$$Wx = \sum (Sij \times Xi) / \sum Sij \qquad (2)$$

By using Expressions (1) and (2) above, the coil position measuring unit 13d calculates the position Wz in the Z-axis direction and the position Wx in the X-axis direction, for each of all the coil elements included in the array coil 8b. In this situation, as explained above, the spatial positions in the profile data for the coil elements and for the WB coil are expressed by using the couch coordinate system. Accordingly, the positions of the coil elements are also expressed by using the couch coordinate system.

Further, after having measured the positions of the coil elements, the coil position measuring unit 13d measures the position of the array coil 8b, by using the positions of the coil elements and the coil position information stored in the coil position measuring unit 13d.

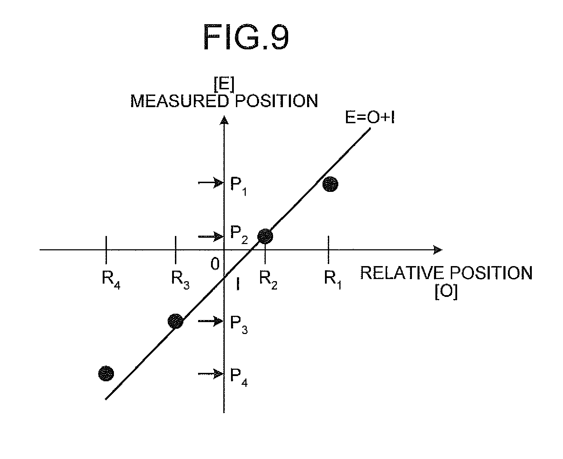

FIG. 9 is a drawing for explaining the array coil position measuring process performed by the coil position measuring unit 13d according to the first embodiment. For example, let us assumed that, among the coil elements included in the array coil 8b, the calculated measured positions of the four coil elements arranged next to one another in the Z-axis direction are expressed as $P_1$, $P_2$, $P_3$, and $P_4$. Further, let us assume that, within the coil position measured information stored in the coil position measuring unit 13d, the relative positions of these four coil elements are expressed as $R_1$, $R_2$, $R_3$, and $R_4$. In this situation, as shown in FIG. 9, for example, the coil position measuring unit 13d calculates the value of the intercept I by using a least-squares method, with respect to a linear function E=O+I defined by using the relative position of each of the coil elements in the coil position information as an explanatory variable E and using the measured position of each of the coil elements as an objective variable O.

In this situation, the coil position measuring unit 13d calculates the value of the intercept I, for each of all the sets of coil elements arranged next to one another in the Z-axis direction that are included in the array coil 8b. As shown in FIG. 2, the array coil 8b includes three sets of coil elements each made up of four coil elements arranged next to one another in the Z-axis direction. Accordingly, the coil position measuring unit 13d calculates a value of the intercept I, for each of the three sets. Further, for example, the coil position measuring unit 13d calculates the average of the three calculated values and determines the calculated average as the position of the array coil 8b in the Z-axis direction.

In the sections above, the example is explained in which the position of the array coil 8b in the Z-axis direction is calculated based on the measured positions of the coil elements arranged next to one another in the Z-axis direction. However, the exemplary embodiments are not limited to this example. It is also acceptable to calculate the position of the array coil 8b in the X-axis direction, based on the measured positions of the coil elements arranged next to one another in the X-axis direction, by using the same method. Further, it is also acceptable to measure a two-dimensional position of the array coil 8b, by calculating the positions in the X-axis direction and in the Z-axis direction.

Further, in the sections above, the example is explained in which the position of the array coil 8b is calculated by using the least-squares method; however, the exemplary embodiments are not limited to this example. It is also acceptable to use any other statistical method that is commonly used in a regression analysis. For example, in the sections above, the example is explained in which the regression analysis is performed by using the linear function E=O+I; however, it is also acceptable to perform a regression analysis by using any other function such as a quadratic function or an exponential function. In those situations, for example, by using the measured positions and the relative positions of the coil elements as sample data, the coil position measuring unit 13d estimates the value of a coefficient included in a predetermined function. As a result, an approximate equation E=f(O) is obtained, which indicates the relationship between the relative position of each of the coil elements expressed by using the representative position of the array coil as a reference and the measured position of each of the coil elements. Further, by calculating the value of E when O=0 is satisfied while using the obtained approximate equation E-f(O), the coil position measuring unit 13d calculates the position of the array coil 8b in the Z-axis direction.

After that, when having calculated the positions of the coil elements and the array coil by using the methods described above, the coil position measuring unit 13d outputs, for example, information indicating the calculated positions, to the display unit 15. For example, the coil position measuring unit 13d displays one or both of the positions of the coil elements and the position of the array coil, on a user interface that is used for setting the image taking condition.

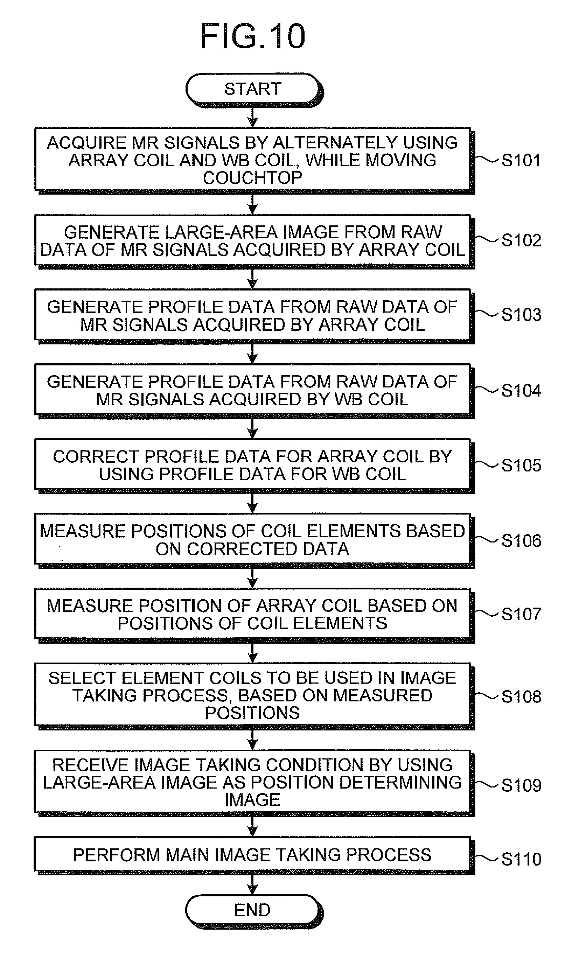

Next, a flow in a process performed by the MRI apparatus 100 according to the first embodiment will be explained. FIG. 10 is a flowchart of the flow in the process performed by the MRI apparatus 100 according to the first embodiment. In the following sections, an example will be explained in which, of the array coils 8a to 8e, the array coil 8b is used.

As shown in FIG. 10, in the MRI apparatus 100 according to the first embodiment, the data acquisition controlling unit 17a first repeatedly acquires MR signals corresponding to the one-dimensional direction, by alternately using the array coil 8b and the WB coil 6, while moving the couchtop 4a (step S101).

Subsequently, the large-area image generating unit 13a generates a large-area image from the raw data of the MR signals acquired by the array coil 8b (step S102).

Further, the profile data generating unit 13b generates profile data from the raw data of the MR signals acquired by the coil elements included in the array coil 8b (step S103). Further, the profile data generating unit 13b generates profile data from the raw data of the MR signals acquired by the WB coil 6 (step S104).

Subsequently, the data correcting unit 13c corrects the profile data for the array coil 8b, by using the profile data for the WB coil 6 (step S105).

After that, based on the corrected data generated by the data correcting unit 13c, the coil position measuring unit 13d measures the positions of the coil elements included in the array coil 8b (step S106). Further, based on the measured positions of the coil elements, the coil position measuring unit 13d measures the position of the array coil (step S107).

After that, based on the positions measured by the coil position measuring unit 13d, the data acquisition controlling unit 17a selects element coils to be used in an image taking process (step S108). For example, based on the positions measured by the coil position measuring unit 13d, the data acquisition controlling unit 17a specifies element coils that are positioned in a valid range of a predetermined size centered on the center of the magnetic filed and selects the specified element coils as the element coils to be used in the image taking process.

Subsequently, the data acquisition controlling unit 17a receives an image taking condition from the operator, while using the large-area image generated by the large-area image generating unit 13a, as a position determining image (step S109). For example, the data acquisition controlling unit 17a displays the large-area image generated by the large-area image generating unit 13a on the display unit 15 as the position determining image and receives, from the operator, an operation to set a Region of Interest (ROI) with respect to the position determining image. Further, the data acquisition controlling unit 17a generates a pulse sequence for acquiring the MR signals from an image taking region of the subject that is indicated by the region of interest specified in the position determining image.

Further, the computer system 10 performs a main image taking process, based on the image taking condition received from the operator (step S110). More specifically, the data acquisition controlling unit 17a acquires the MR signals from the subject P, by controlling the gradient power source 3, the couch controlling unit 5, the transmitting unit 7, and the receiving unit 9, according to the generated pulse sequence. Further, the data processing unit 13 reconstructs an image of the subject P from the raw data based on the MR signals acquired by the data acquisition controlling unit 17a.

In the processing procedure above, another arrangement is acceptable in which, after the profile data for the array coil 8b is corrected by the data correcting unit 13c, the data processing unit 13 corrects the large-area image generated by the large-area image generating unit 13a, by using the corrected profile data. In that situation, for example, the data processing unit 13 corrects the large-area image by multiplying the large-area image generated by the large-area image generating unit 13a by "the strength of the MR signal in the profile data for the WB coil 6"/"the strength of the MR signal in the profile data for each of the coil elements". This correction corresponds to multiplying the large-area image by a reciprocal of the signal value obtained as a result of the correction performed by the data correcting unit 13c to correct the strength of the MR signal in the profile data of each of the coil elements. As a result of this correction, because the parts of the large-area image having smaller signal values are emphasized, it is possible to obtain a more precise large-area image.

In the sections above, the example is explained in which, after the large-area image is generated by the large-area image generating unit 13a, the coil position measuring unit 13d measures the positions of the coil elements and the array coil; however, the order in which the processes are performed by the MRI apparatus 100 is not limited to this example. For example, another arrangement is acceptable in which, after the positions of the coil elements and the array coil are measured by the coil position measuring unit 13d, the large-area image generating unit 13a generates the large-area image. As another example, it is also acceptable for the large-area image generating unit 13a and the coil position measuring unit 13d to perform the processes in parallel.

As explained above, in the first embodiment, the data acquisition controlling unit 17a acquires the MR signals by repeatedly selecting and exciting the cross-sections perpendicular to the moving direction of the couchtop 4a, while continuously moving the couchtop 4a on which the subject P having the array coil 8b attached thereon is placed. Further, the large-area image generating unit 13a generates the large-area image of the subject P, based on the MR signals acquired by the data acquisition controlling unit 17a. Further, the coil position measuring unit 13d measures the positions of the coil elements included in the array coil 8b, based on the strengths of the MR signals used for generating the large-area image and the positions of the couchtop 4a corresponding to the times when the MR signals were acquired. With these arrangements, according to the first embodiment, it is possible to take the large-area image of the subject and to measure the positions of the receiving coils, by moving the couch one time. Thus, it is possible to reduce the number of times the couch needs to be moved. As a result, when it is necessary to take a large-area image of a subject and measure the positions of the receiving coils, it is possible to shorten the time period required by the medical examination.

In addition, in the first embodiment, the data acquisition controlling unit 17a acquires the MR signals while alternately switching between the array coil 8b and the WB coil 6. Further, based on the strengths of the MR signals received by the WB coil 6, the data correcting unit 13c corrects the fluctuations in the strengths of the MR signals acquired by the coil elements, the fluctuations being caused by the characteristic differences among the different parts of the subject P. Further, the coil position measuring unit 13d measures the positions of the coil elements by using the corrected data generated by the data correcting unit 13c. With these arrangements, according to the first embodiment, it is possible to correct the fluctuations in the strengths of the MR signals that are caused by the characteristic differences among the different parts of the subject. Consequently, it is possible to precisely measure the positions of the coil elements.

<Second Embodiment>

Next, a second embodiment will be explained. In the first embodiment, the example is explained in which the MR signals corresponding to the one-dimensional direction perpendicular to the moving direction of the couchtop 4a are acquired so as to take the large-area image of the subject and to measure the positions of the receiving coils. In the second embodiment below, an example will be explained in which, by acquiring MR signals corresponding to two-dimensional directions perpendicular to the moving direction of the couchtop 4a, a large-area image of the subject is taken, and positions of the receiving coils are measured, and further, a sensitivity map indicating a distribution of sensitivities of the coil elements is generated.

The overall configuration of an MRI apparatus according to the second embodiment is the same as the one shown in FIG. 1, except that the configuration of the computer system is different. For this reason, the second embodiment will be explained while a focus is placed on functions of the computer system. The second embodiment will also be explained with an example in which the large-area image is taken and the positions of the coil elements are measured by using the array coil 8b; however it is possible to similarly take a large-area image and measure the positions of the coil elements by using any other array coil.

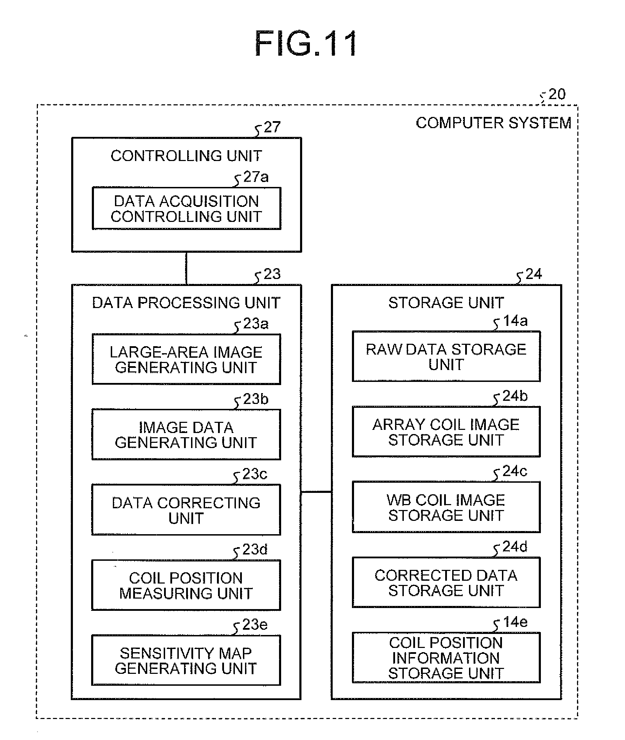

FIG. 11 is a functional block diagram of a detailed configuration of a computer system 20 according to the second embodiment. FIG. 11 depicts configurations of a data processing unit 23, a storage unit 24, and a controlling unit 27 included in the computer system 20 according to the second embodiment. In the following sections, some of the functional units that have the same rolls as those of the functional units shown in FIG. 3 will be referred to by using the same reference characters, and the detailed explanation thereof will be omitted.

As shown in FIG. 11, the storage unit 24 includes the raw data storage unit 14a, an array coil image storage unit 24b, a WB coil image storage unit 24c, a corrected data storage unit 24d, and a coil position information storage unit 24e.

The array coil image storage unit 24b stores therein cross-section images generated based on the MR signals received by the array coils 8a to 8e. In the following sections, the cross-section images generated based on the MR signals received by the array coils 8a to 8e will be referred to as "array coil images". The array coil images are generated by an image data generating unit 23b, which is explained later.

The WB coil image storage unit 24c stores therein cross-section images generated based on the MR signals received by the WB coil 6. In the following sections, the cross-section images generated based on the MR signals received by the WB coil 6 will be referred to as "WB coil images". The WB coil images are generated by the image data generating unit 23b, which is explained later.

The corrected data storage unit 24d stores therein corrected images obtained by correcting, based on the strengths of the MR signals received by the WB coil 6, fluctuations in the signal strengths of the MR signals acquired by the coil elements, the fluctuations being caused by characteristic differences among different parts of the subject P. The corrected images are generated by a data correcting unit 23c, which is explained later.

The controlling unit 27 includes a data acquisition controlling unit 27a.

The data acquisition controlling unit 27a acquires the MR signals by repeatedly selecting and exciting cross sections perpendicular to the moving direction of the couchtop 4a, while continuously moving the couchtop 4a on which the subject P having the array coil 8b attached thereon is placed. More specifically, in the same manner as in the first embodiment, the data acquisition controlling unit 27a continuously moves, in the Z-axis direction, the couchtop 4a on which the subject P having the array coil 8b attached thereon is placed. The subject P is placed on the couchtop 4a so that the body axis thereof extends along the Z-axis direction. Further, the data acquisition controlling unit 27a repeatedly executes a pulse sequence for acquiring the MR signals by selecting and exciting an axial cross-section AX perpendicular to the moving direction of the couchtop 4a, while moving the couchtop 4a.

Further, according to the second embodiment, the data acquisition controlling unit 27a acquires the MR signals corresponding to the two-dimensional directions perpendicular to the moving direction of the couchtop 4a. For example, by repeatedly executing a pulse sequence for a single-shot Fast Spin Echo (FSE), the data acquisition controlling unit 27a acquires MR signals corresponding to the X-axis direction. In this situation, the single-shot FSE refers to an image taking method by which a refocusing-purpose pulse is repeatedly applied to the subject, after an exciting-purpose pulse is applied thereto, so that it is possible to acquire a plurality of MR signals (echo signals) with one-time excitation. Further, the data acquisition controlling unit 27a repeatedly performs the data acquisition by controlling the receiving unit 9 so as to alternately switch between the array coil 8b and the WB coil 6, every time MR signals are acquired.

The image taking method used by the data acquisition controlling unit 27a to acquire the MR signals is not limited to the example in which a plurality of MR signals are acquired with one-time excitation. For example, the data acquisition controlling unit 27a may acquire the MR signals by using a Field Echo (FE)-based image taking method. In that situation, for example, the data acquisition controlling unit 27a repeatedly performs a data acquisition by alternately switching between the array coil 8b and the WB coil 6, for every repetition time (TR), which is a time period from the start of the obtainment of one signal to the start of the obtainment of the next signal.

The data processing unit 23 includes a large-area image generating unit 23a, the image data generating unit 23b, the data correcting unit 23c, a coil position measuring unit 23d, and a sensitivity map generating unit 23e.

The large-area image generating unit 23a generates a large-area image of the subject P, based on the MR signals acquired by the data acquisition controlling unit 27a. More specifically, the large-area image generating unit 23a reads, from the raw data storage unit 14a, the raw data based on the MR signals received by the coil elements included in the array coil 8b and generates the image of the subject P having a large area in the Z-axis direction, from the read raw data.

More specifically, the pieces of raw data based on the MR signals acquired by the data acquisition controlling unit 27a are sequentially read, according to a time sequence, by the large-area image generating unit 23a. The large-area image generating unit 23a then generates a plurality of pieces of image data expressing a real space in the two-dimensional directions by applying a two-dimensional Fourier transform to each of the read pieces of raw data. Further, by arranging the pieces of image data generated by the two-dimensional Fourier transform into the real space in an order according to the time sequence, the large-area image generating unit 23a generates three-dimensional image data of the subject P. In this situation, the large-area image generating unit 23a determines the positioning intervals between the pieces of image data in the real space, according to the moving amounts of the couchtop 4a in the time intervals with which the MR signals were acquired. By arranging the pieces of data in the real space according to the moving amounts of the couchtop 4a in this manner, it is possible to generate the large-area image that properly expresses the shape of the subject. Further, the large-area image generating unit 23a generates the image of the subject P, by performing a process to change the generated three-dimensional image data into two-dimensional data, such as a Maximum Intensity Projection (MIP) process, a Multi-Planar Reconstruction (MPR) process, or the like.

Based on the MR signals received by each of the plurality of coil elements 80 included in the array coils 8a to 8e, the image data generating unit 23b generates, for each of the coil elements 80, image data indicating a distribution of the strengths of the MR signals in the two-dimensional directions perpendicular to the moving direction of the couchtop 4a.

More specifically, the image data generating unit 23b reads the raw data based on the MR signals acquired by each of the coil elements included in the array coil 8b, out of the raw data storage unit 14a. In this situation, the image data generating unit 23b reads the raw data used by the large-area image generating unit 23a to generate the large-area image. In this situation, because the image data generating unit 23b uses the same raw data as the raw data used for generating the large-area image, it becomes possible to both take the large-area image and measure the positions of the coil elements, based on the same set of MR signals that are acquired by moving the couchtop one time.

Further, from the read raw data, the image data generating unit 23b generates, for each of the coil elements 80, image data indicating a distribution of the strengths of the MR signals in the X-Y axis directions, as an array coil image. For example, the image data generating unit 23b generates the array coil image by applying a two-dimensional Fourier transform to the raw data. Further, the image data generating unit 23b stores the array coil image generated for each of the coil elements into the array coil image storage unit 24b.

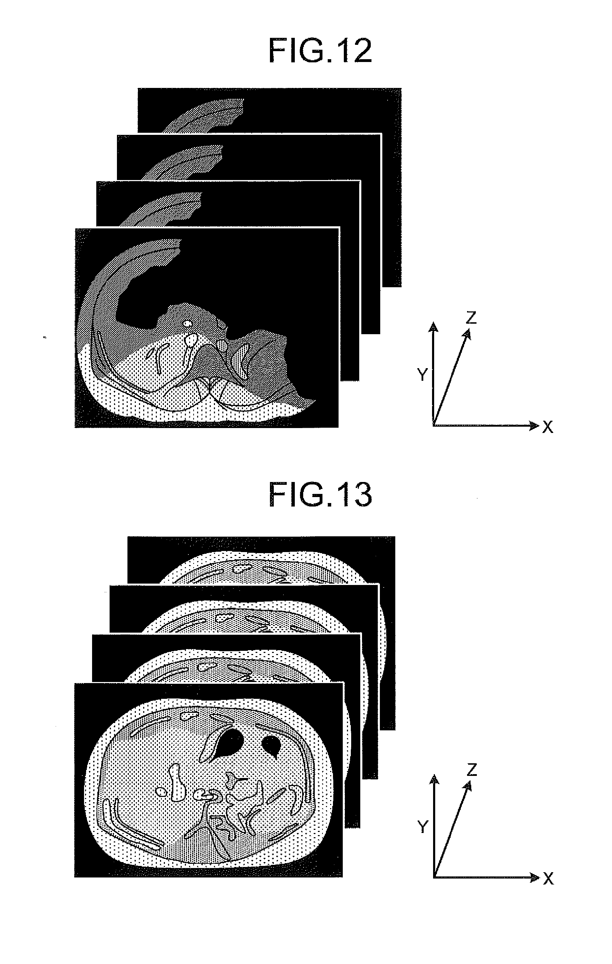

FIG. 12 is a drawing of exemplary array coil images for the coil elements 80 generated by the image data generating unit 23b according to the second embodiment. In FIG. 12, the X-axis expresses the spatial position in the X-axis direction. Further, the Y-axis expresses the spatial position in the Y-axis direction. Also, the Z-axis expresses the spatial position in the Z-axis direction. In this situation, the spatial positions in the X-axis direction, the Y coordinate, and the Z-axis direction are expressed by using a couch coordinate system that uses a predetermined position on the couchtop 4a as the origin. For example, the origin of the couch coordinate system is set at the center of the couchtop 4a. The couch coordinate system is configured so that the entire coordinate system moves in the Z-axis direction, as the couchtop 4a moves.

As shown in FIG. 12, the image data generating unit 23b generates array coil images for the coil elements, for each of the positions of the couchtop 4a in the Z-axis direction corresponding to the points in time when the MR signals on which the array coil images are based were acquired. For example, every time array coil images are generated, the image data generating unit 23b obtains, from the controlling unit 27, a moving amount of the couchtop 4a corresponding to the time when the MR signals on which the array coil images are based were acquired, calculates the position of the couchtop 4a based on the obtained moving amount, and brings the calculated position into correspondence with the array coil image.

Further, the image data generating unit 23b reads the raw data based on the MR signals acquired by the WB coil 6 out of the raw data storage unit 14a and generates, as WB coil images, image data indicating a distribution of the strengths of the MR signals in the X-Y axis directions, based on the read raw data. For example, like the array coil images related to the coil elements, the image data generating unit 23b generates the WB coil images, by applying a two-dimensional Fourier transform to the raw data. Further, the image data generating unit 23b stores the generated WB coil images into the WB coil image storage unit 24c.

FIG. 13 is a drawing of exemplary WB coil images generated by the image data generating unit 23b according to the second embodiment. In FIG. 13, the X-axis expresses the spatial position in the X-axis direction. Further, the Y-axis expresses the spatial position in the Y-axis direction. Also, the Z-axis expresses the spatial position in the Z-axis direction. In this situation, the spatial positions in the X-axis, the Y-axis, and the Z-axis directions are expressed by using the couch coordinate system described above, like in the array coil images for the element coils.

As shown in FIG. 13, the image data generating unit 23b generates a WB coil image, for each of the positions of the couchtop 4a in the Z-axis direction corresponding to the points in time when the MR signals on which the WB coil images are based were acquired. For example, every time a WB coil image is generated, the image data generating unit 23b obtains, from the controlling unit 27, a moving amount of the couchtop 4a corresponding to the time when the MR signals on which the WB coil image is based were acquired, calculates the position of the couchtop 4a based on the obtained moving amount, and brings the calculated position into correspondence with the WB coil image.

Returning to the description of FIG. 11, based on the strengths of the MR signals received by the WB coil 6, the data correcting unit 23c corrects fluctuations in the signal strengths of the MR signals acquired by the coil elements, the fluctuations being caused by characteristic differences among different parts of the subject P.

More specifically, the data correcting unit 23c reads the array coil image for each of the coil elements included in the array coil 8b out of the array coil image storage unit 24b, and also, reads the WB coil images out of the WB coil image storage unit 24c. Further, the data correcting unit 23c generates corrected images obtained by correcting the array coil images for the coil elements, by dividing the strength of the MR signal in the array coil image for each of the coil elements by the strength of the MR signal in the WB coil image. After that, the data correcting unit 23c stores the generated corrected images into the corrected data storage unit 24d. In this situation, because the data correcting unit 23c corrects the array coil image for each of the coil elements based on the WB coil images, it is possible to correct the fluctuations in the strengths of the MR signals, the fluctuations being caused by the characteristic differences among the different parts of the subject.

The coil position measuring unit 23d measures the positions of the coil elements, based on the strengths of the MR signals used for generating the large-area image and the positions of the couchtop 4a corresponding to the times when the MR signals were acquired.

More specifically, the coil position measuring unit 23d reads the corrected images for the coil elements included in the array coil 8b out of the corrected data storage unit 24d and adds together the signal values of the signals included in the read corrected images in the Y-axis direction. After that, the coil position measuring unit 23d extracts only such signals of which the signal values resulting from the addition exceed a predetermined threshold. In this situation, because the coil position measuring unit 23d uses only such signals of which the signal values (i.e., the signal strengths) exceed the predetermined threshold, signals that are considered to be noises are eliminated from the MR signals received by the coil elements. As a result, because the position of the representative position of the receiving coils is calculated by using only the signals having a high reliability, it is possible to measure the positions of the coil elements more precisely.

Further, for example, by calculating the position of a gravity point of the signal values of the extracted signals, the coil position measuring unit 23d calculates the positions of the coil elements. For example, in the same manner as in the first embodiment, the coil position measuring unit 23d calculates the position Wz in the Z-axis direction and the position Wx in the X-axis direction, for each of all the coil elements included in the array coil 8b, by using Expressions (1) and (2). In this situation, as explained above, the spatial positions in the array coil images and the WB coil images are expressed by using the couch coordinate system. Accordingly, the positions of the coil elements are also expressed by using the couch coordinate system.

After that, when having measured the positions of the coil elements, the coil position measuring unit 23d measures the position of the array coil 8b in the same manner as in the first embodiment, by using the measured positions of the coil elements and the coil position information stored in the coil position measuring unit 23d (see FIG. 9). After that, when having calculated the positions of the coil elements and the array coil by using the method described above, the coil position measuring unit 23d outputs, for example, information indicating the calculated positions, to the display unit 15. For example, the coil position measuring unit 23d displays one or both of the positions of the coil elements and the position of the array coil, on a user interface that is used for setting the image taking condition.

The sensitivity map generating unit 23e generates a sensitivity map indicating a distribution of sensitivities of the coil elements, by using the array coil images and the WB coil images. More specifically, when the array coil images are generated by the image data generating unit 23b, the sensitivity map generating unit 23e reads the generated array coil images for each of the coil elements, out of the array coil image storage unit 24b. Further, when the WB coil images are generated by the image data generating unit 23b, the sensitivity map generating unit 23e reads the generated WB coil images out of the WB coil image storage unit 24c. After that, the sensitivity map generating unit 23e generates a sensitivity map for each of the coil elements, by comparing each of the read array coil images with the WB coil images.

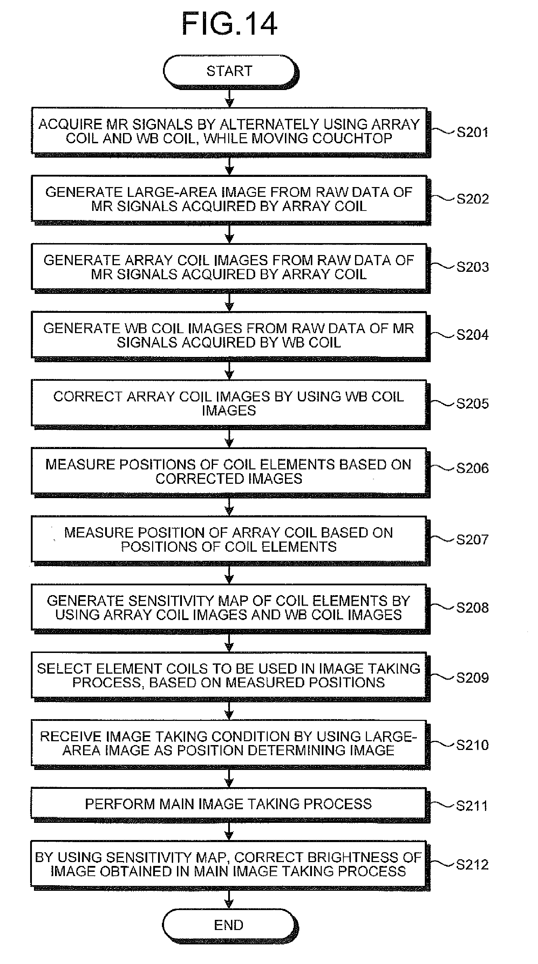

Next, a flow in a process performed by the MRI apparatus according to the second embodiment will be explained. FIG. 14 is a flowchart of the flow in the process performed by the MRI apparatus according to the second embodiment. In the following sections, an example will be explained in which, of the array coils 8a to 8e, the array coil 8b is used.

As shown in FIG. 14, in the MRI apparatus 100 according to the second embodiment, the data acquisition controlling unit 27a first repeatedly acquires MR signals corresponding to the two-dimensional directions, by alternately using the array coil 8b and the WB coil 6, while moving the couchtop 4a (step S201).

Subsequently, the large-area image generating unit 23a generates a large-area image from the raw data of the MR signals acquired by the array coil 8b (step S202).

Further, the image data generating unit 23b generates array coil images from the raw data of the MR signals acquired by the coil elements included in the array coil 8b (step S203). Further, the image data generating unit 23b generates WB coil images from the raw data of the MR signals acquired by the WB coil 6 (step S204).

Subsequently, the data correcting unit 23c corrects the array coil images for the coil elements, by using the WB coil images (step S205).

After that, based on the corrected images generated by the data correcting unit 23c, the coil position measuring unit 23d measures the positions of the coil elements included in the array coil 8b (step S206). Further, based on the measured positions of the coil elements, the coil position measuring unit 23d measures the position of the array coil (step S207).

Subsequently, the sensitivity map generating unit 23e generates a sensitivity map indicating a distribution of the sensitivities of the coil elements, by using the array coil images and the WB coil images (step S208).

After that, based on the positions measured by the coil position measuring unit 23d, the data acquisition controlling unit 27a selects element coils to be used in an image taking process (step S208). For example, based on the positions measured by the coil position measuring unit 23d, the data acquisition controlling unit 27a specifies element coils that are positioned in a valid range of a predetermined size centered on the center of the magnetic filed and selects the specified element coils as the element coils to be used in the image taking process.

Subsequently, the data acquisition controlling unit 27a receives an image taking condition from the operator, while using the large-area image generated by the large-area image generating unit 23a, as a position determining image (step S209). For example, the data acquisition controlling unit 27a displays the large-area image generated by the large-area image generating unit 23a on the display unit 15 as the position determining image and receives, from the operator, an operation to set a Region of Interest (ROI) with respect to the position determining image. Further, the data acquisition controlling unit 27a generates a pulse sequence for acquiring the MR signals from an image taking region of the subject that is indicated by the region of interest specified in the position determining image.

Further, the computer system 20 performs a main image taking process, based on the image taking condition received from the operator (step S210). More specifically, the data acquisition controlling unit 27a acquires the MR signals from the subject P, by controlling the gradient power source 3, the couch controlling unit 5, the transmitting unit 7, and the receiving unit 9, according to the generated pulse sequence. Further, the data processing unit 23 reconstructs an image of the subject P from the raw data based on the MR signals acquired by the data acquisition controlling unit 27a. After that, by using a sensitivity map generated by the sensitivity map generating unit 23e, the data processing unit 23 corrects brightness of the image obtained in the main image taking process (step S222).

In the processing procedure described above, another arrangement is acceptable in which, after the sensitivity map is generated by the sensitivity map generating unit 23e, the data processing unit 13 corrects the brightness of the large-area image generated by the large-area image generating unit 23a, by using the generated sensitivity map. With this arrangement, because it is possible to make the signal levels in the large-area image uniform, it is possible to reduce unevenness among the brightness levels occurring in the large-area image.

Further, in the sections above, the example is explained in which, after the large-area image is generated by the large-area image generating unit 23a, the coil position measuring unit 23d measures the positions of the coil elements and the array coil; however, the order in which the processes are performed by the MRI apparatus 100 is not limited to this example. For example, another arrangement is acceptable in which, after the positions of the coil elements and the array coil are measured by the coil position measuring unit 23d, the large-area image generating unit 23a generates the large-area image. As another example, it is also acceptable for the large-area image generating unit 23a and the coil position measuring unit 23d to perform the processes in parallel. As yet another example, as long as the array coil images and the WB coil image have already been generated, it is also acceptable for the sensitivity map generating unit 23e to generate the sensitivity map before the positions of the coil elements are measured by the coil position measuring unit 23d.

As explained above, in the second embodiment, the data acquisition controlling unit 27a acquires the MR signals by repeatedly selecting and exciting the cross-sections perpendicular to the moving direction of the couchtop 4a, while continuously moving the couchtop 4a on which the subject P having the array coil 8b attached thereon is placed. Further, the large-area image generating unit 23a generates the large-area image of the subject P, based on the MR signals acquired by the data acquisition controlling unit 27a. Further, the coil position measuring unit 23d measures the positions of the coil elements included in the array coil 8b, based on the strengths of the MR signals used for generating the large-area image and the positions of the couchtop 4a corresponding to the times when the MR signals were acquired. With these arrangements, according to the second embodiment, it is possible to take the large-area image of the subject and to measure the positions of the receiving coils, by moving the couch one time. Thus, it is possible to reduce the number of times the couch needs to be moved. As a result, when it is necessary to take a large-area image of a subject and measure the positions of the receiving coils, it is possible to shorten the time period required by the medical examination.

In addition, in the second embodiment, the data acquisition controlling unit 27a acquires the MR signals while alternately switching between the array coil 8b and the WB coil 6. Further, based on the strengths of the MR signals received by the WB coil 6, the data correcting unit 23c corrects the fluctuations in the strengths of the MR signals acquired by the coil elements, the fluctuations being caused by the characteristic differences among the different parts of the subject P. Further, the coil position measuring unit 23d measures the positions of the coil elements by using the corrected data generated by the data correcting unit 23c. With these arrangements, according to the second embodiment, it is possible to correct the fluctuations in the strengths of the MR signals that are caused by the characteristic differences among the different parts of the subject. Consequently, it is possible to precisely measure the positions of the coil elements.

Furthermore, in the second embodiment, the image data generating unit 23b generates the array coil images based on the MR signals acquired by the array coil 8b and generates the WB coil images based on the MR signals acquired by the WB coil. Further, the sensitivity map generating unit 23e generates the sensitivity map indicating the distribution of the sensitivities of the coil elements by using the array coil images and the WB coil images. As a result, according to the second embodiment, it is possible to take the large-area image of the subject, to measure the positions of the receiving coils, and to generate the sensitivity map, by moving the couch one time. Consequently, when it is necessary to take a large-area image of a subject, measure the positions of the receiving coils, and generate a sensitivity map, it is possible to shorten the time period required by the medical examination.

Further, in the second embodiment described above, the example is explained in which the data acquisition controlling unit 27a acquires the MR signals corresponding to the X-Y axis directions, while continuously moving the couchtop 4a in the Z-axis direction. In this example, because the couchtop 4a moves even while the MR signals are being acquired from one cross-section, the image data generated for the cross section has a gap in the Z-axis direction between the lines in the X-axis direction.

To cope with this situation, another arrangement is acceptable in which, for example, while the data acquisition controlling unit 27a is acquiring a plurality of MR signals that are required to reconstruct an image of one cross section, the data acquisition controlling unit 27a moves the position to be selected and excited by following the move of the couchtop 4a. In that situation, for example, the data acquisition controlling unit 27a moves the position to be selected and excited by controlling a carrier frequency offset for the refocusing-purpose pulse.

For example, the data acquisition controlling unit 27a controls a carrier frequency offset $\Delta f_k$ for the k'th refocusing-purpose pulse applied (k≥1), based on Expression (3) shown below.

$$\Delta f_k = \Delta f_0 + \{\gamma \bullet Gs \bullet V \bullet ETS \bullet (k-1/2)\}/2\pi \quad [Hz] \qquad (3)$$

In Expression (3), $\gamma$ denotes the gyromagnetic ratio; $Gs$ denotes the strength [T/m] of a gradient pulse in the slicing direction; $V$ denotes the moving speed [m/s] of the couchtop 4a; $\Delta f_0$ denotes the carrier frequency offset for an exciting-purpose pulse applied first; and $ETS$ denotes the interval [s] between the MR signals (the echo signals).

As explained above, while the data acquisition controlling unit 27a is acquiring the plurality of MR signals that are required to reconstruct the image of one cross section, the data acquisition controlling unit 27a moves the position to be selected and excited by following the move of the couchtop 4a. As a result, it is possible to measure the positions of the receiving coils more precisely.

It is desirable if the position to be selected and excited for a WB coil image is the same as the position to be selected and excited for the array coil image paired with the WB coil image. For this reason, even while the data acquisition controlling unit 27a is acquiring the MR signals related to a WB coil image, the data acquisition controlling unit 27a moves the position to be selected and excited by following the move of the couchtop 4a. For example, the data acquisition controlling unit 27a controls a carrier frequency offset $\Delta f_{kWB}$ for the k' th refocusing-purpose pulse applied (k≥1) during the acquisition using the WB coil, based on Expression (4) shown below.

$$\Delta f_{kWB} = \Delta f_{0PAC} + [\gamma \bullet Gs \bullet V \bullet \{ETS \bullet (k-1/2) + \Delta T\}]/2\pi \quad [Hz] \qquad (4)$$

In Expression (4), $\Delta f_{0PAC}$ denotes a carrier frequency offset for a refocusing-purpose pulse applied first during the acquisition using the array coil; and $\Delta T$ denotes the difference between the starting time of the acquisition using the array coil and the starting time of the acquisition using the WB coil.

As explained above, by moving the position to be selected and excited by following the move of the couchtop 4a during the acquisition using the array coil and the acquisition using the WB coil, it is possible to generate a more precise sensitivity map.

Further, in the first and the second embodiments above, the example is explained in which the profile data or the array coil images are generated for each of the coil elements included in the array coil 8b; however, the exemplary embodiments are not limited to this example. For example, it is acceptable to synthesize MR signals received by two or more of the coil elements, so as to generate profile data or an array coil image for each of the synthesized MR signals.

In that situation, for example, the receiving unit 9 synthesizes the MR signals received by two or more of the plurality of coil elements that are arranged next to one another in a direction perpendicular to the moving direction of the couchtop 4a. Further, by using the MR signals synthesized by the receiving unit 9, the coil position measuring unit 13d measures the position of the coil element group made up of the two or more of the coil elements that are arranged next to one another in the direction perpendicular to the moving direction of the couchtop 4a.

<Third Embodiment>

In the first and the second embodiments, the data acquisition controlling unit acquires the magnetic resonance signals, while changing the position to be selected and excited within the subject who has the array coil attached thereon. More specifically, in the first and the second embodiments, the example is explained in which the data acquisition controlling unit acquires the MR signals by repeatedly selecting and exciting the cross sections perpendicular to the moving direction of the couchtop, while continuously moving the couchtop on which the subject is placed.

However, the methods for collecting the MR signals are not limited to those explained in the first and the second embodiments. For example, the data acquisition controlling unit may acquire MR signals by repeatedly selecting and exciting cross sections perpendicular to the moving direction of the couchtop, while intermittently moving the couchtop on which the subject is placed. This method may be called a "step and shoot" method. In the following sections, an example using the "step and shoot" method will be explained as a third embodiment.

A data acquisition controlling unit according to the third embodiment repeatedly alternates moving and stopping of the couchtop on which the subject is placed, so as to acquire the MR signals by changing, while the couchtop is stopped, the position to be selected and excited within the subject along the moving direction of the couchtop.

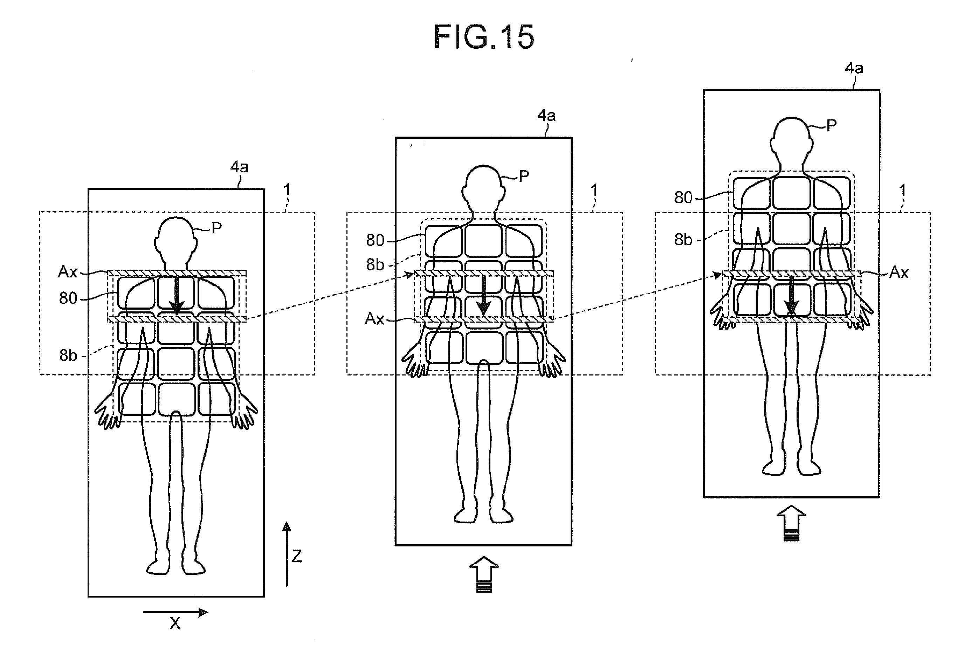

FIG. 15 is a drawing for explaining a data acquisition performed by the data acquisition controlling unit according to the third embodiment. As shown in FIG. 15 from the left-hand side to the right-hand side, for example, the data acquisition controlling unit according to the third embodiment repeatedly alternates the Z-axis-direction moving and the stopping of the couchtop 4a on which the subject P having the array coil 8b attached thereon is placed. In this situation, each of the sections of FIG. 15 (left, middle, and right) depicts a state in which the couchtop 4a is stopped. Also, as shown in FIG. 15, the subject P is placed on the couchtop 4a so that the body axis thereof extends along the Z-axis direction.

Further, the data acquisition controlling unit acquires the MR signals by changing, while the couchtop 4a is stopped, the position to be selected and excited within the subject P along the moving direction of the couchtop 4a. For example, the data acquisition controlling unit moves, while the couchtop 4a is stopped, the axial cross-section AX to be selected and excited in the direction opposite to the moving direction of the couchtop 4a, by a distance equal to the moving distance of the couchtop 4a (see the bold solid arrows in FIG. 15).

Further, when the couchtop 4a has been moved, the data acquisition controlling unit moves back the position of the axial cross-section AX to be selected and excited in the moving direction of the couchtop 4a, by a distance equal to the moving distance of the couchtop 4a (see the broken-line arrows in FIG. 15). The data acquisition controlling unit repeats the moving and the stopping of the couchtop 4a in this manner and repeatedly executes the pulse sequence for acquiring the MR signals by moving, while the couchtop 4a is stopped, the position of the axial cross-section AX to be selected and excited.

Further, although the explanation will be omitted, in the third embodiment also, the large-area image generating unit generates a large-area image of the subject, based on the MR signals acquired by the data acquisition controlling unit, so that the coil position measuring unit measures the positions of the coil elements based on the strengths of the MR signals used for generating the large-area image and the positions of the couchtop corresponding to the times when the MR signals were acquired. As a result, in the third embodiment also, it is possible to take the large-area image of the subject and measure the positions of the receiving coils. Thus, it is possible to reduce the number of times the couch needs to be moved.

In the third embodiment described above, the position to be selected and excited within the subject is moved while the couchtop 4a is stopped. For this reason, in the third embodiment, it is desirable to perform, in combination, a process to correct distortions that occur in the image due to non-uniformity of the magnetic fields in the image taking space.

As explained above, according to the first, the second, and the third embodiments, when it is necessary to take a large-area image of a subject and measure the positions of the receiving coils, it is possible to shorten the time period required by the medical examination.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A magnetic resonance imaging apparatus comprising:

   an array coil structured by arranging a plurality of coil elements therein each of which receives a magnetic resonance signal generated from a subject;
   an acquisition controlling unit configured to acquire the magnetic resonance signals, while changing a position to be selected and excited within the subject who has the array coil attached thereon;
   a large-area image generating unit configured to generate a large-area image of the subject, based on the magnetic resonance signals acquired by the acquisition controlling unit; and
   a position measuring unit configured to measure positions of the coil elements, based on strengths of the magnetic resonance signals used for generating the large-area image and positions of the couchtop corresponding to times when the magnetic resonance signals were acquired.

2. The magnetic resonance imaging apparatus according to claim 1, further comprising: a couchtop on which the subject is placed, wherein
   the acquisition controlling unit acquires the magnetic resonance signals by repeatedly selecting and exciting cross sections perpendicular to a moving direction of the couchtop, while continuously moving the couchtop on which the subject is placed.

3. The magnetic resonance imaging apparatus according to claim 1, further comprising: a couchtop on which the subject is placed, wherein
the acquisition controlling unit repeatedly alternates moving and stopping of the couchtop on which the subject is placed, and the acquisition controlling unit acquires the magnetic resonance signals by changing, while the couchtop is stopped, the position to be selected and excited within the subject, along a moving direction of the couchtop.

4. The magnetic resonance imaging apparatus according to claim 1, 2, or 3, further comprising: a whole-body coil positioned so as to surround the subject and configured to receive magnetic resonance signals generated from the subject, wherein
the acquisition controlling unit acquires the magnetic resonance signals while alternately switching between the array coil and the whole-body coil.

5. The magnetic resonance imaging apparatus according to claim 4, further comprising: a correcting unit configured to correct fluctuations in strengths of the magnetic resonance signals acquired by the coil elements, the fluctuations being caused by characteristic differences among different parts of the subject, wherein
the position measuring unit measures the positions of the coil elements by using corrected data generated by the correcting unit.

6. The magnetic resonance imaging apparatus according to claim 1, 2, or 3, wherein the acquisition controlling unit acquires the magnetic resonance signals corresponding to a one-dimensional direction perpendicular to the moving direction of the couchtop.

7. The magnetic resonance imaging apparatus according to claim 6, wherein the large-area image generating unit generates a plurality of pieces of data expressing a real space in the one-dimensional direction by applying a one-dimensional Fourier transform to each of pieces of raw data based on the magnetic resonance signals acquired by the acquisition controlling unit in a time sequence and generates the large-area image by arranging the generated pieces of data into the real space in an order according to the time sequence.

8. The magnetic resonance imaging apparatus according to claim 1, 2, or 3, wherein the acquisition controlling unit acquires the magnetic resonance signals corresponding to two-dimensional directions perpendicular to the moving direction of the couchtop.

9. The magnetic resonance imaging apparatus according to claim 4 further comprising:

an image data generating unit configured to generate first image data based on the magnetic resonance signals acquired by the coil elements and to generate second image data based on the magnetic resonance signals acquired by the whole-body coil; and
a sensitivity map generating unit configured to generate a sensitivity map indicating a distribution of sensitivities of the coil elements, by using the first image data and the second image data.

10. The magnetic resonance imaging apparatus according to claim 9, further comprising: an image correcting unit configured to correct brightness of the large-area image generated by the large-area image generating unit, by using the sensitivity map generated by the sensitivity map generating unit.

11. The magnetic resonance imaging apparatus according to claim 8, wherein, while acquiring a plurality of magnetic resonance signals that are required to reconstruct an image of one cross section, the acquisition controlling unit moves the position to be selected and excited by following the move of the couchtop.

12. The magnetic resonance imaging apparatus according to claim 8, wherein the large-area image generating unit generates a plurality of pieces of image data expressing a real space in two-dimensional directions by applying a two-dimensional Fourier transform to each of pieces of raw data based on the magnetic resonance signals acquired by the acquisition controlling unit in a time sequence, generates three-dimensional image data of the subject by arranging the generated pieces of image data into the real space in an order according to the time sequence, and generates the large-area image by performing a process to change the generated three-dimensional image data into two-dimensional data.

13. The magnetic resonance imaging apparatus according to claim 1, 2, or 3, further comprising: a synthesizing unit configured to synthesize magnetic resonance signals received by two or more of the plurality of coil elements that are arranged next to one another in a direction perpendicular to the moving direction of the couchtop, wherein

the position measuring unit measures a position of a coil element group made up of the two or more of the coil elements that are arranged next to one another in the direction perpendicular to the moving direction of the couchtop, by using the magnetic resonance signals synthesized by the synthesizing unit.

**14.** The magnetic resonance imaging apparatus according to claim 4, further comprising:

a correcting unit configured to correct, based on strengths of the magnetic resonance signals received by the whole-body coil, fluctuations in strengths of the magnetic resonance signals acquired by the coil elements, the fluctuations being caused by characteristic differences among different parts of the subject; and
an image correcting unit configured to correct the large-area image generated by the large-area image generating unit, by using corrected data generated by the correcting unit.

# FIG.1

EP 2 532 303 A1

# FIG.2

# FIG.3

# FIG.4

| COIL NAME | ARRAY COIL EXTERIOR DIMENSION (x, y, z) [mm] | ELEMENT NUMBER | ELEMENT EXTERIOR DIMENSION (x, y, z) [mm] | RELATIVE POSITION (x, y, z) [mm] |
|---|---|---|---|---|
| ARRAY COIL A | ⋯ | ⋯ | ⋯ | ⋯ |
| ⋮ | ⋮ | ⋮ | ⋮ | ⋮ |
| ARRAY COIL B | (520, 50, 420) | 1 | (110, 10, 120) | (-140, 0, 195) |
| ARRAY COIL B | (520, 50, 420) | 2 | (110, 10, 120) | (0, 0, 195) |
| ARRAY COIL B | (520, 50, 420) | 3 | (110, 10, 120) | (140, 0, 195) |
| ARRAY COIL B | (520, 50, 420) | 4 | (110, 10, 120) | (-140, 0, 65) |
| ARRAY COIL B | (520, 50, 420) | 5 | (110, 10, 120) | (0, 0, 65) |
| ARRAY COIL B | (520, 50, 420) | 6 | (110, 10, 120) | (140, 0, 65) |
| ARRAY COIL B | (520, 50, 420) | 7 | (110, 10, 120) | (-140, 0, -65) |
| ARRAY COIL B | (520, 50, 420) | 8 | (110, 10, 120) | (0, 0, -65) |
| ARRAY COIL B | (520, 50, 420) | 9 | (110, 10, 120) | (140, 0, -65) |
| ARRAY COIL B | (520, 50, 420) | 10 | (110, 10, 120) | (-140, 0, -195) |
| ARRAY COIL B | (520, 50, 420) | 11 | (110, 10, 120) | (0, 0, -195) |
| ARRAY COIL B | (520, 50, 420) | 12 | (110, 10, 120) | (140, 0, -195) |
| ARRAY COIL C | ⋯ | ⋯ | ⋯ | ⋯ |
| ⋮ | ⋮ | ⋮ | ⋮ | ⋮ |
| ARRAY COIL D | ⋯ | ⋯ | ⋯ | ⋯ |
| ⋮ | ⋮ | ⋮ | ⋮ | ⋮ |

# FIG.5

## FIG.6

~60

## FIG.7

## FIG.8

# FIG.9

# FIG.10

START

ACQUIRE MR SIGNALS BY ALTERNATELY USING ARRAY COIL AND WB COIL, WHILE MOVING COUCHTOP ～S101

GENERATE LARGE-AREA IMAGE FROM RAW DATA OF MR SIGNALS ACQUIRED BY ARRAY COIL ～S102

GENERATE PROFILE DATA FROM RAW DATA OF MR SIGNALS ACQUIRED BY ARRAY COIL ～S103

GENERATE PROFILE DATA FROM RAW DATA OF MR SIGNALS ACQUIRED BY WB COIL ～S104

CORRECT PROFILE DATA FOR ARRAY COIL BY USING PROFILE DATA FOR WB COIL ～S105

MEASURE POSITIONS OF COIL ELEMENTS BASED ON CORRECTED DATA ～S106

MEASURE POSITION OF ARRAY COIL BASED ON POSITIONS OF COIL ELEMENTS ～S107

SELECT ELEMENT COILS TO BE USED IN IMAGE TAKING PROCESS, BASED ON MEASURED POSITIONS ～S108

RECEIVE IMAGE TAKING CONDITION BY USING LARGE-AREA IMAGE AS POSITION DETERMINING IMAGE ～S109

PERFORM MAIN IMAGE TAKING PROCESS ～S110

END

# FIG.11

COMPUTER SYSTEM ⌇20

**CONTROLLING UNIT** ⌇27

DATA ACQUISITION
CONTROLLING UNIT ⌇27a

**DATA PROCESSING UNIT** ⌇23

LARGE-AREA IMAGE
GENERATING UNIT ⌇23a

IMAGE DATA
GENERATING UNIT ⌇23b

DATA CORRECTING
UNIT ⌇23c

COIL POSITION
MEASURING UNIT ⌇23d

SENSITIVITY MAP
GENERATING UNIT ⌇23e

**STORAGE UNIT** ⌇24

RAW DATA STORAGE
UNIT ⌇14a

ARRAY COIL IMAGE
STORAGE UNIT ⌇24b

WB COIL IMAGE
STORAGE UNIT ⌇24c

CORRECTED DATA
STORAGE UNIT ⌇24d

COIL POSITION
INFORMATION
STORAGE UNIT ⌇14e

# FIG.12

# FIG.13

# FIG.14

START

```
ACQUIRE MR SIGNALS BY ALTERNATELY USING ARRAY
COIL AND WB COIL, WHILE MOVING COUCHTOP                    S201

GENERATE LARGE-AREA IMAGE FROM RAW DATA OF
MR SIGNALS ACQUIRED BY ARRAY COIL                         S202

GENERATE ARRAY COIL IMAGES FROM RAW DATA OF
MR SIGNALS ACQUIRED BY ARRAY COIL                         S203

GENERATE WB COIL IMAGES FROM RAW DATA OF MR
SIGNALS ACQUIRED BY WB COIL                              S204

CORRECT ARRAY COIL IMAGES BY USING WB COIL
IMAGES                                                   S205

MEASURE POSITIONS OF COIL ELEMENTS BASED ON
CORRECTED IMAGES                                         S206

MEASURE POSITION OF ARRAY COIL BASED ON
POSITIONS OF COIL ELEMENTS                               S207

GENERATE SENSITIVITY MAP OF COIL ELEMENTS BY
USING ARRAY COIL IMAGES AND WB COIL IMAGES               S208

SELECT ELEMENT COILS TO BE USED IN IMAGE TAKING
PROCESS, BASED ON MEASURED POSITIONS                     S209

RECEIVE IMAGE TAKING CONDITION BY USING LARGE-
AREA IMAGE AS POSITION DETERMINING IMAGE                 S210

PERFORM MAIN IMAGE TAKING PROCESS                        S211

BY USING SENSITIVITY MAP, CORRECT BRIGHTNESS OF
IMAGE OBTAINED IN MAIN IMAGE TAKING PROCESS              S212
```

END

FIG.15

## INTERNATIONAL SEARCH REPORT

| International application No. |
| --- |
| PCT/JP2011/068565 |

A. CLASSIFICATION OF SUBJECT MATTER
*A61B5/055*(2006.01)i

According to International Patent Classification (IPC) or to both national classification and IPC

B. FIELDS SEARCHED

Minimum documentation searched (classification system followed by classification symbols)
A61B5/055

Documentation searched other than minimum documentation to the extent that such documents are included in the fields searched

| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | WO 2008/146228 A1 (KONINKLIJKE PHILIPS ELECTRONICS N.V.), 04 December 2008 (04.12.2008), description, page 6, lines 16 to 20; page 10, lines 25 to 33 & JP 2010-527729 A    & US 2010/0189328 A1 & EP 2156206 A1      & CN 101680938 A | 1-14 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 14 November, 2011 (14.11.11) | 22 November, 2011 (22.11.11) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**EP 2 532 303 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10179551 A

- US 6794872 B